# EUROPEAN PATENT APPLICATION

(11) **EP 2 043 270 A2**
(43) Date of publication of application: **01.04.2009**
(21) Application number: 08016783.6
(22) Date of filing: 24.09.2008
(51) Int. Cl.: H04B 1/10, H04B 1/26

(54) **Receiving digital television broadcasting**

(30) Priority: 27.09.2007 JP 2007251781
(71) Applicant: SANYO Electric Co., Ltd., Moriguchi-shi Osaka 570-8677 (JP); Sanyo Tuner Industries CO., LTD, Daito-shi, Osaka 574-8534 (JP)
(72) Inventor: Okuma, Hideyuki, Hirata-shi Osaka 573-0163 (JP); Fujiura, Hideaki, Higashiosaka-shi Osaka 578-0972 (JP)
(74) Representative: Glawe, Delfs, Moll

(57) **Abstract**

In a receiving unit, an AGC circuit (5) controls the gain of a high frequency amplifier (4) based on an output signal of a mixer (7), that is, an intermediate frequency signal obtained before an unnecessary frequency component is removed by a BPF (9). Therefore, deterioration in the distortion characteristic of the mixer (7) can be suppressed more effectively than a conventional case where the gain of the high frequency amplifier (4) is controlled based on an intermediate frequency signal that has passed through the BPF (9) and amplified by an intermediate frequency amplifier (10).

## Description

### BACKGROUND OF THE INVENTION

### Field of the Invention

The present invention relates to a receiving unit, and in particular, to a receiving unit receiving digital television broadcasting.

### Description of the Background Art

Conventionally, in a receiving unit receiving analog television broadcasting, a high frequency signal received by an antenna is amplified by a high frequency amplifier, the amplified high frequency signal is converted into an intermediate frequency signal by a mixer, an unnecessary frequency component in the generated intermediate frequency signal is attenuated by a band pass filter (BPF), the intermediate frequency signal that has passed through the BPF is amplified by an intermediate frequency amplifier, a desired frequency component in the amplified intermediate frequency signal is extracted by a surface acoustic wave filter, the extracted intermediate frequency signal is demodulated by a demodulator, and the gain of the high frequency amplifier is controlled by an auto gain control (AGC) circuit based on an input signal of the demodulator. In the receiving unit, accurate gain control can be implemented for a desired wave, because gain control for the high frequency amplifier is performed based on the input signal of the demodulator.

Further, in a receiving unit receiving digital television broadcasting, an AGC circuit controls the gain of a high frequency amplifier based on an intermediate frequency signal amplified by an intermediate frequency amplifier at a stage preceding a surface acoustic wave filter. In the receiving unit, when a disturbance wave having a level higher than that of a desired wave is present adjacent to a desired channel, the disturbance wave is detected and the gain of the high frequency amplifier is reduced, and thereby deterioration in the distortion characteristic of a mixer can be suppressed (for example, see Japanese Patent Laying-Open No. 2005-136790).

In a conventional receiving unit, however, a disturbance wave component adjacent to a desired channel is attenuated by a BPF for intermediate frequency, and thus the disturbance wave component is not fully detected at a subsequent stage thereof, resulting in unsatisfactory gain control by an AGC circuit. Therefore, deterioration in the distortion characteristic of a mixer cannot be fully suppressed, causing a problem that a disturbance wave adjacent to a desired channel is generated adjacent to an intermediate frequency band, and a harmonic generated by the distortion in the mixer interferes with a desired intermediate frequency signal.

### SUMMARY OF THE INVENTION

Accordingly, a main object of the present invention is to provide a receiving unit capable of fully suppressing deterioration in the distortion characteristic of a mixer.

A receiving unit in accordance with the present invention is a receiving unit receiving digital television broadcasting, including: a high frequency amplifier amplifying a high frequency signal received by an antenna; a mixer converting the high frequency signal amplified by the high frequency amplifier into an intermediate frequency signal; a first filter attenuating an unnecessary frequency component in the intermediate frequency signal generated by the mixer; an intermediate frequency amplifier amplifying the intermediate frequency signal that has passed through the first filter; a second filter extracting a desired frequency component in the intermediate frequency signal amplified by the intermediate frequency amplifier; and a gain control circuit controlling a gain of the high frequency amplifier based on the intermediate frequency signal obtained before the unnecessary frequency component is attenuated by the first filter.

Therefore, deterioration in the distortion characteristic of the mixer can be suppressed more effectively than a conventional case where the gain of the high frequency amplifier is controlled based on an output signal of the intermediate frequency amplifier.

Further, another receiving unit in accordance with the present invention is a receiving unit receiving digital television broadcasting, including: a high frequency amplifier amplifying a high frequency signal received by an antenna; a mixer converting the high frequency signal amplified by the high frequency amplifier into an intermediate frequency signal; a first filter attenuating an unnecessary frequency component in the intermediate frequency signal generated by the mixer; an intermediate frequency amplifier amplifying the intermediate frequency signal that has passed through the first filter; a second filter extracting a desired frequency component in the intermediate frequency signal amplified by the intermediate frequency amplifier; a selection circuit selecting one of the intermediate frequency signal obtained before the unnecessary frequency component is attenuated by the first filter and the intermediate frequency signal amplified by the intermediate frequency amplifier, based on a reception characteristic; and a gain control circuit controlling a gain of the high frequency amplifier based on the intermediate frequency signal selected by the selection circuit.

In this instance, a case with better reception characteristic can be selected from cases where the gain of the high frequency amplifier is controlled based on the intermediate frequency signal obtained before the unnecessary frequency component is attenuated by the first filter and where the gain of the high frequency amplifier is controlled based on the intermediate frequency signal amplified by the intermediate frequency amplifier.

Furthermore, still another receiving unit in accordance with the present invention is a receiving unit receiving digital television broadcasting, including: a high frequency amplifier amplifying a high frequency signal received by an antenna; a mixer converting the high frequency signal amplified by the high frequency amplifier into an intermediate frequency signal; a first filter attenuating an unnecessary frequency component in the intermediate frequency signal generated by the mixer; an intermediate frequency amplifier amplifying the intermediate frequency signal that has passed through the first filter; a second filter extracting a desired frequency component in the intermediate frequency signal amplified by the intermediate frequency amplifier; a demodulator demodulating the intermediate frequency signal extracted by the second filter, and outputting an error signal when accurate demodulation cannot be performed; a selection circuit selecting one of the intermediate frequency signal obtained before the unnecessary frequency component is attenuated by the first filter and the intermediate frequency signal amplified by the intermediate frequency amplifier, and selecting the other of the intermediate frequency signals in response to an output of the error signal from the demodulator; and a gain control circuit controlling a gain of the high frequency amplifier based on the intermediate frequency signal selected by the selection circuit.

In this instance, when the gain of the high frequency amplifier is controlled based on the intermediate frequency signal obtained before the unnecessary frequency component is attenuated by the first filter, and as a result, the gain of the high frequency amplifier is lowered too much, the gain of the high frequency amplifier can be increased by controlling the gain of the high frequency amplifier based on the intermediate frequency signal amplified by the intermediate frequency amplifier. In contrast, when the gain of the high frequency amplifier is controlled based on the intermediate frequency signal amplified by the intermediate frequency amplifier, and as a result, the distortion characteristic of the mixer is deteriorated, deterioration in the distortion characteristic of the mixer can be suppressed effectively by controlling the gain of the high frequency amplifier based on the intermediate frequency signal obtained before the unnecessary frequency component is attenuated by the first filter.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a block diagram illustrating a configuration of a receiving unit in accordance with one embodiment of the present invention.
Fig. 2 is a block diagram illustrating a comparative example of the embodiment.
Fig. 3 shows the attenuation characteristic of a BPF shown in Figs. 1 and 2.
Figs. 4A and 4B show the disturbance wave characteristics of the receiving units shown in Figs. 1 and 2.
Fig. 5 is a block diagram illustrating a modification of the embodiment.

### DESCRIPTION OF THE PREFERRED EMBODIMENTS

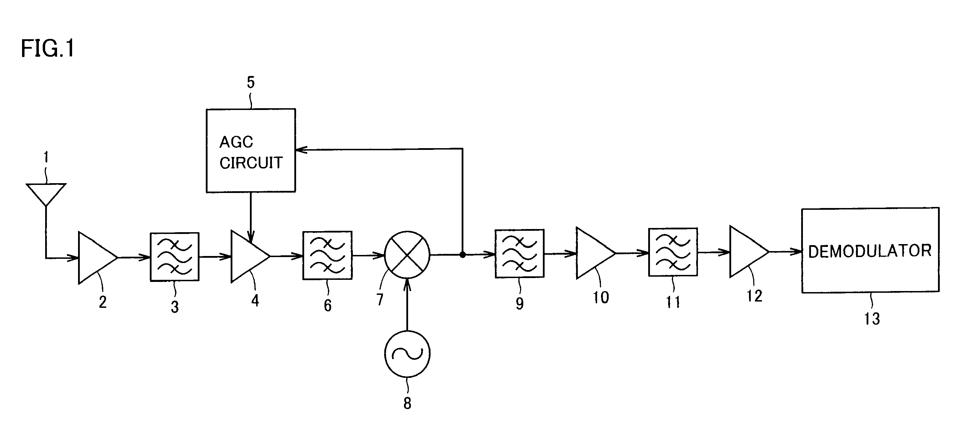

Referring to Fig. 1, a receiving unit in accordance with one embodiment of the present invention is a receiving unit receiving digital television broadcasting, including an antenna 1, a low noise amplifier (LNA) 2, frequency variable BPFs 3 and 6, a high frequency amplifier 4, an AGC circuit 5, a mixer 7, a local oscillator 8, an intermediate frequency BPF 9, intermediate frequency amplifiers 10 and 12, a surface acoustic wave filter 11, and a demodulator 13.

A radio wave (a high frequency signal) transmitted from a digital television broadcasting station is received by antenna 1, and subjected to low noise amplification by LNA 2. An unnecessary frequency component in the high frequency signal subjected to low noise amplification by LNA 2 is attenuated by frequency variable BPF 3. The high frequency signal that has passed through BPF 3 is amplified by high frequency amplifier 4. The gain of high frequency amplifier 4 is controlled based on the result of detection by AGC circuit 5.

An unnecessary frequency component in the high frequency signal amplified by high frequency amplifier 4 is attenuated by frequency variable BPF 6. The high frequency signal that has passed through BPF 6 is converted into an intermediate frequency signal by mixer 7. Mixer 7 mixes a local oscillation signal generated by local oscillator 8 and the high frequency signal to generate the intermediate frequency signal. AGC circuit 5 controls the gain of high frequency amplifier 4 based on the intermediate frequency signal generated by mixer 7.

An unnecessary frequency component in the intermediate frequency signal generated by mixer 7 is attenuated by intermediate frequency BPF 9. The intermediate frequency signal that has passed through BPF 9 is amplified by intermediate frequency amplifier 10. A desired frequency component in the intermediate frequency signal amplified by intermediate frequency amplifier 10 is extracted by surface acoustic wave filter 11. The intermediate frequency signal extracted by surface acoustic wave filter 11 is amplified by intermediate frequency amplifier 12 and supplied to demodulator 13. Demodulator 13 demodulates the intermediate frequency signal from intermediate frequency amplifier 12 to generate an image signal or the like. A television receiver displays a television program in response to the image signal.

BPFs 3 and 6 are set to have a wide pass band, BPF 9 is set to have a narrow pass band, and surface acoustic wave filter 11 is set to have an extremely narrow pass band. Further, the pass band for filters 3 and 6 is shifted according to a channel selected by a viewer of the television receiver. The oscillation frequency of local oscillator 8 is also shifted according to a selected channel.

In the present embodiment, when a disturbance wave having a level higher than that of a desired wave is present in an adjacent channel, the disturbance wave is detected and the gain of high frequency amplifier 4 is reduced, and thereby deterioration in the distortion characteristic of mixer 7 can be suppressed. Further, since the gain of high frequency amplifier 4 is controlled based on the intermediate frequency signal obtained before the unnecessary frequency component is attenuated by BPF 9, deterioration in the distortion characteristic of mixer 7 can be suppressed more effectively than a conventional case where the gain of high frequency amplifier 4 is controlled based on an output signal of intermediate frequency amplifier 10.

It is to be noted that, when a disturbance wave having a level higher than that of a desired wave is present in an adjacent channel, gain control is performed on the basis of the level of the disturbance wave, and thus the signal level of the desired wave is decreased and the S/N (signal to noise) characteristic is deteriorated. However, since a digital broadcasting signal has high resistance to noise, some deterioration in the S/N characteristic does not cause reduction in image quality.

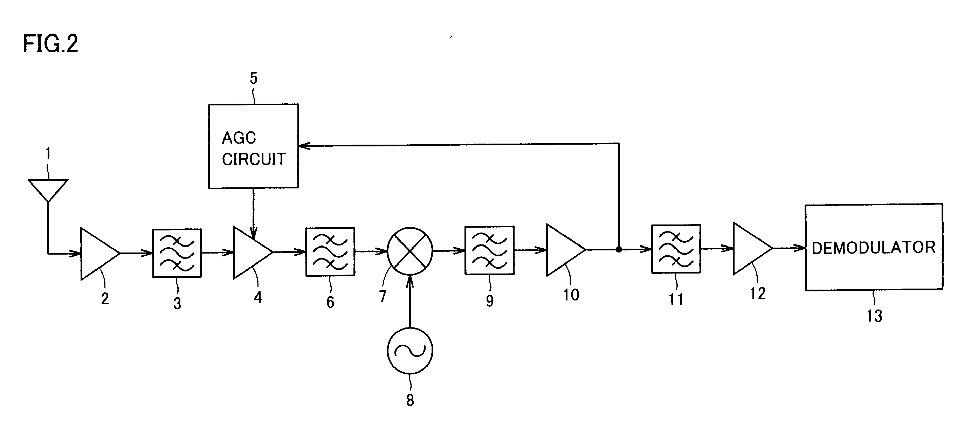

Next, the effect of the receiving unit will be described in more detail. Fig. 2 is a block diagram illustrating a configuration of a receiving unit serving as a comparative example of the present embodiment, which is compared with Fig. 1. The receiving unit shown in Fig. 2 is different from the receiving unit shown in Fig. 1 in that AGC circuit 5 controls the gain of high frequency amplifier 4 based on the intermediate frequency signal amplified by intermediate frequency amplifier 10.

In the comparative example, the level of the disturbance wave is lowered by BPF 9, and the detection level of AGC circuit 5 is reduced. Accordingly, AGC circuit 5 increases the gain of high frequency amplifier 4, and thereby the level of the high frequency signal input to mixer 7 is increased, causing deterioration in the distortion characteristic of mixer 7.

In contrast, in the receiving unit of Fig. 1, the detection level of AGC circuit 5 is increased because the detection is performed before BPF 9. Accordingly, AGC circuit 5 reduces the gain of high frequency amplifier 4, and thereby the level of the high frequency signal input to mixer 7 is lowered, suppressing deterioration in the distortion characteristic of mixer 7.

It is to be noted that, since mixer 7 includes a semiconductor element, distortion occurs in an output signal when the level of an input signal is increased. Further, when distortion occurs in mixer 7, reception disturbance occurs. For example, when a high frequency signal of 100 MHz is received and the high frequency signal is converted into an intermediate frequency signal of 44 MHz, a local oscillation signal of 144 MHz is generated at local oscillator 8. If a disturbance wave of 130 MHz deviated from a desired wave of 100 MHz by five channels is present, the disturbance wave is converted into an intermediate frequency signal of 14 MHz derived from 144 MHz minus 130 MHz. The signal of 14 MHz does not cause reception disturbance as it is attenuated by filters 9 and 11. When distortion occurs in mixer 7, however, a harmonic having a frequency three times higher than the frequency of 14 MHz of the intermediate frequency signal (i.e., a harmonic of 42 MHz) is generated. The harmonic overlaps the intermediate frequency signal of 44 MHz described above and causes reception disturbance.

Accordingly, it is necessary to suppress the distortion in mixer 7. To suppress the distortion in mixer 7, it is effective to reduce the level of the input signal of mixer 7. Since the level of the disturbance wave is higher than the level of the desired wave between high frequency amplifier 4 and surface acoustic wave filter 11, the detection level of AGC circuit 5 is determined by the level of the disturbance wave. Therefore, the level of the input signal of mixer 7 is more reduced when AGC circuit 5 performs detection at a position where the level of the disturbance wave is higher, suppressing the distortion in mixer 7. Consequently, concerning the distortion in mixer 7, the receiving unit of Fig. 1 is more advantageous than the receiving unit of Fig. 2.

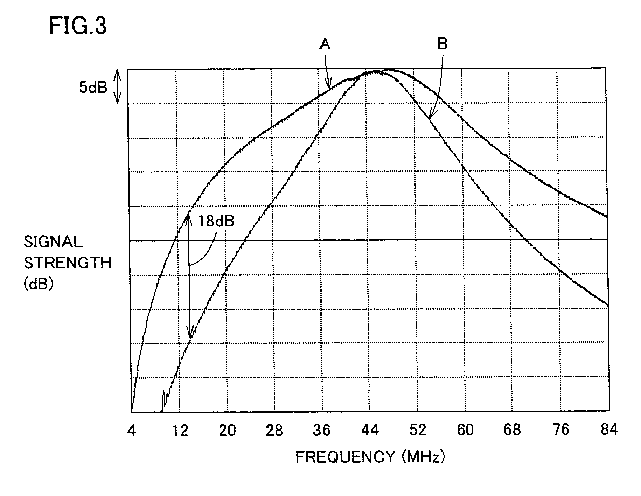

Fig. 3 shows the attenuation characteristic of BPF 9. The horizontal axis of Fig. 3 represents frequency (MHz), and one scale indicates 8 MHz. The central value of the frequency is set at 44 MHz described above. The vertical axis of Fig. 3 represents signal strength (dB), and one scale indicates 5 dB. It is now assumed that an input signal of BPF 9 has a waveform as shown by an upper curve A in Fig. 3. When the signal passes through BPF 9, the waveform of the signal changes to a waveform as shown by a lower curve B in Fig. 3. It can been seen from Fig. 3 that the frequency component of a desired channel (44 MHz) in the output signal of mixer 7 is hardly attenuated, and the more the frequency component is deviated from the desired channel, the more the frequency component is attenuated. For example, the frequency component at 14 MHz deviated by five channels is attenuated by 18 dB. Since the detection level of AGC circuit 5 in the receiving unit of Fig. 1 is 18 dB higher than that in the receiving unit of Fig. 2, the level of the signal input to mixer 7 is reduced, which is advantageous for the distortion in mixer 7.

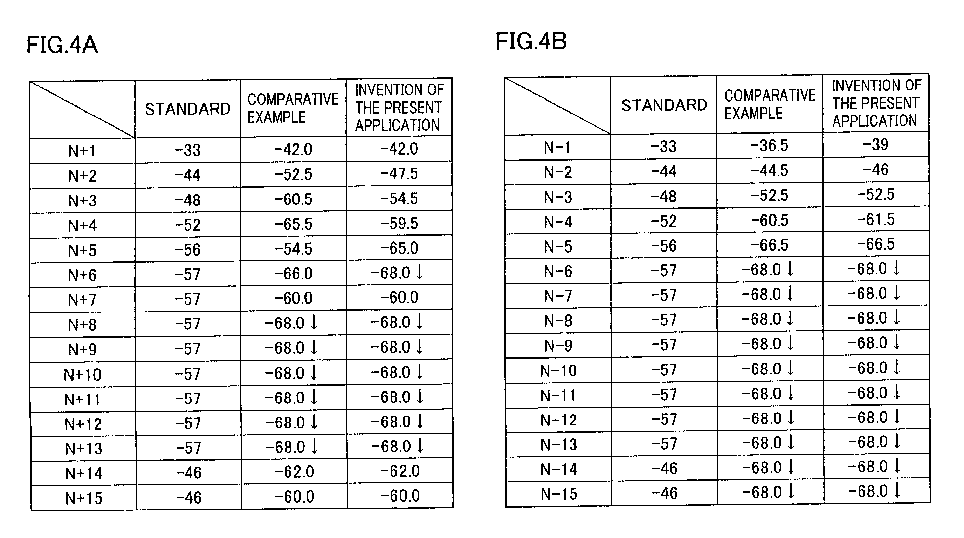

Further, Figs. 4A and 4B show the disturbance wave characteristics of the receiving units. The values (dB) in the tables indicate how much the level of the disturbance wave can be increased on the basis of the level of the desired wave. Whether or not the disturbance wave is permissible is determined by whether or not accurate demodulation can be performed by demodulator 13. Accordingly, the lower the value is (i.e., the greater the absolute value of the value is), the less the reception disturbance due to the disturbance wave occurs.

As shown in the left columns of the tables, in the United States, the standard for a characteristic value of the disturbance wave in each of channels N+1 to N+15 and N-1 to N-15 on the basis of a desired channel N has been established. In the comparative example, as shown in the central columns of the tables, although the standard is met in all the channels other than N+5, the value in channel N+5 (-54.5) is higher than the standard value (-56). As described above, reception disturbance is likely to occur due to the disturbance wave in channel N+5. In contrast, in the invention of the present application, as shown in the right columns of the tables, the standard is met in all the channels, and the value in channel N+5 (-65) is also sufficiently lower than the standard value (-56).

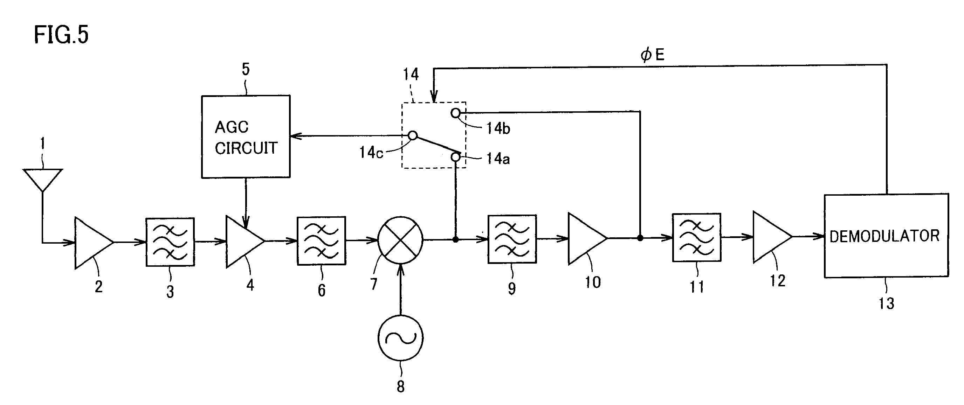

Fig. 5 is a block diagram illustrating a modification of the present embodiment, which is compared with Fig. 1. A receiving unit shown in Fig. 5 is different from the receiving unit shown in Fig. 1 in that a switch 14 is added. Switch 14 has one switching terminal 14a connected to an output node of mixer 7, the other switching terminal 14b connected to an output node of intermediate frequency amplifier 10, and a common terminal 14c connected to an input node of AGC circuit 5. Switch 14 is switched whenever an error signal φE output from demodulator 13 is raised from an inactive "L" level to an active "H" level.

It is now assumed that conduction is established between terminals 14a and 14c of switch 14. In this instance, the intermediate frequency signal generated by mixer 7 is supplied to AGC circuit 5 via switch 14. Thereby, the gain of high frequency amplifier 4 is maintained low, and deterioration in the distortion characteristic of mixer 7 is suppressed.

When the gain of high frequency amplifier 4 is set low, and as a result, the level of the desired wave is lowered too much and accurate demodulation cannot be performed, demodulator 13 raises error signal φE to an active "H" level. In response, switch 14 is switched to establish conduction between terminals 14b and 14c, and the output signal of intermediate frequency amplifier 10 is supplied to AGC circuit 5 via switch 14. Thereby, the gain of high frequency amplifier 4 is increased and the level of the desired wave is increased, enabling accurate demodulation. When accurate demodulation can be performed, error signal φE is fallen to an inactive "L" level.

When the gain of high frequency amplifier 4 is increased, and as a result, the distortion characteristic of mixer 7 is deteriorated and reception disturbance occurs, demodulator 13 raises error signal φE to an active "H" level. In response, switch 14 is switched to establish conduction between terminals 14a and 14c, and the output signal of mixer 7 is supplied to AGC circuit 5 via switch 14. Thereby, the gain of high frequency amplifier 4 is maintained low, and deterioration in the distortion characteristic of mixer 7 is suppressed. When deterioration in the distortion characteristic of mixer 7 is suppressed and reception disturbance is resolved, error signal φE is fallen to an inactive "L" level.

In other words, in this modification, the state shown in Fig. 1 and the state shown in Fig. 2 are switched alternately in response to a rising edge of error signal φE. Therefore, demodulation can be performed more stably than in the present embodiment.

It is to be noted that, although LNA 2 is provided at a stage subsequent to antenna 1 in the present embodiment and the modification thereof, it is needless to say that the present invention is also applicable to a receiving unit not provided with LNA 2.

It should be understood that the embodiment disclosed herein is illustrative and non-restrictive in every respect. The scope of the present invention is defined by the terms of the claims, rather than the description above, and is intended to include any modifications within the scope and meaning equivalent to the terms of the claims.

## Claims

1. A receiving unit receiving digital television broadcasting, comprising:
a high frequency amplifier (4) amplifying a high frequency signal received by an antenna (1);
a mixer (7) converting the high frequency signal amplified by said high frequency amplifier (4) into an intermediate frequency signal;
a first filter (9) attenuating an unnecessary frequency component in the intermediate frequency signal generated by said mixer (7);
an intermediate frequency amplifier (10) amplifying the intermediate frequency signal that has passed through said first filter (9);
a second filter (11) extracting a desired frequency component in the intermediate frequency signal amplified by said intermediate frequency amplifier (10); and
a gain control circuit (5) controlling a gain of said high frequency amplifier (4) based on the intermediate frequency signal obtained before said unnecessary frequency component is attenuated by said first filter (9).

2. A receiving unit receiving digital television broadcasting, comprising:
a high frequency amplifier (4) amplifying a high frequency signal received by an antenna (1);
a mixer (7) converting the high frequency signal amplified by said high frequency amplifier (4) into an intermediate frequency signal;
a first filter (9) attenuating an unnecessary frequency component in the intermediate frequency signal generated by said mixer (7);
an intermediate frequency amplifier (10) amplifying the intermediate frequency signal that has passed through said first filter (9);
a second filter (11) extracting a desired frequency component in the intermediate frequency signal amplified by said intermediate frequency amplifier (10);
a selection circuit (14) selecting one of the intermediate frequency signal obtained before said unnecessary frequency component is attenuated by said first filter (9) and the intermediate frequency signal amplified by said intermediate frequency amplifier (10), based on a reception characteristic; and
a gain control circuit (5) controlling a gain of said high frequency amplifier (4) based on the intermediate frequency signal selected by said selection circuit (14).

3. A receiving unit receiving digital television broadcasting, comprising:
a high frequency amplifier (4) amplifying a high frequency signal received by an antenna (1);
a mixer (7) converting the high frequency signal amplified by said high frequency amplifier (4) into an intermediate frequency signal;
a first filter (9) attenuating an unnecessary frequency component in the intermediate frequency signal generated by said mixer (7);
an intermediate frequency amplifier (10) amplifying the intermediate frequency signal that has passed through said first filter (9);
a second filter (11) extracting a desired frequency component in the intermediate frequency signal amplified by said intermediate frequency amplifier (10);
a demodulator (13) demodulating the intermediate frequency signal extracted by said second filter (11), and outputting an error signal when accurate demodulation cannot be performed;
a selection circuit (14) selecting one of the intermediate frequency signal obtained before said unnecessary frequency component is attenuated by said first filter (9) and the intermediate frequency signal amplified by said intermediate frequency amplifier (10), and selecting the other of the intermediate frequency signals in response to an output of said error signal from said demodulator (13); and
a gain control circuit (5) controlling a gain of said high frequency amplifier (4) based on the intermediate frequency signal selected by said selection circuit (14).
